# FASCICULE DE BREVET EUROPEEN

(11) **EP 0 397 543 B1**
(45) Date de publication et mention de la délivrance du brevet: **08.09.1993**
(21) Numéro de dépôt: 90401171.5
(22) Date de dépôt: 27.04.1990
(51) Int. Cl.: H05K 5/02

(54) **Boîtier, notamment pour un appareil de mesures électriques, équipé d'une poignée amovible**
Gehäuse, insbesondere für ein elektrisches Messgerät, das mit einem abnehmbaren Handgriff ausgerüstet ist.
Casing, particularly for an electric measuring apparatus, having a removable handle

(30) Priorité: 12.05.1989 FR 8906297
(43) Date de publication de la demande: 14.11.1990
(73) Titulaire: ITT COMPOSANTS ET INSTRUMENTS, F-92220 Bagneux (FR)
(72) Inventeur: Melenotte, Denis,, F-74330 La Balme de Sillingy, (FR); Szobszlai, Istvan,, F-74290 Veyrier du Lac, (FR)
(74) Mandataire: Kohn, Philippe

(56) Documents cités:
- EP-A- 0 106 467
- EP-A- 0 176 644
- DE-B- 1 189 006

## Description

La présente invention a pour objet un boîtier, notamment d'un appareil de mesures électriques, équipé d'une poignée du type comportant une partie de préhension et des moyens de liaison de cette partie au boîtier.

Les appareils de mesures électriques, tel que par exemple celui décrit et représenté dans la demande de brevet français n° 88 12601 déposée le 27 septembre 1988, sont le plus fréquemment des appareils transportables que l'on doit pouvoir déplacer aisément d'un point à un autre d'utilisation. A cet effet il est souhaitable que de tels appareils puissent être équipés d'une poignée qui doit pouvoir être amovible afin de ne pas gêner l'utilisation prolongée de l'appareil de mesures électriques à poste fixe.

Dans ce but l'invention propose un boîtier du type mentionné plus haut, caractérisé en ce que les moyens de liaison sont démontables pour rendre la poignée amovible et comportent au moins un assemblage du type tenon et mortaise dont l'un des deux éléments est formé sur une portion du boîtier et une sangle serrée à la périphérie du boîtier et qui s'étend dans un plan sensiblement perpendiculaire à la direction de coulissement de l'assemblage par tenon et mortaise.

Selon d'autres caractéristiques de l'invention :
- le logement constituant la mortaise est fermé à l'une de ses extrémités axiales pour former une butée d'engagement du tenon ;
- le tenon est un tenon en forme de cheville relié à la partie de préhension par une aile axiale, la mortaise étant un logement cylindrique complémentaire formé dans le boîtier et qui comporte une fente périphérique qui s'ouvre dans une portion de face plane du boîtier pour permettre le passage de l'aile de liaison du tenon ;
- le boîtier comporte deux assemblages identiques du type tenon et mortaise qui sont parallèles entre eux ;
- les deux fentes des deux mortaises s'ouvrent dans la même portion de face plane du boîtier ;
- la poignée est réalisée en matériau élastique, l'assemblage par tenon et mortaise et la sangle étant réalisé venus de matière avec la partie de préhension ;
- la sangle est reçue dans une gorge de profil complémentaire formée dans la paroi externe du boîtier ;
- la sangle est une sangle continue en boucle fermée emboitée élastiquement dans la gorge ;
- le boîtier présente une forme sensiblement parallépipédique rectangle, la sangle s'étendant autour des petites parois latérales du boîtier, et
- le boîtier comporte une gaine souple de protection à laquelle est reliée la poignée selon l'invention.

D'autres caractéristiques et avantages de l'invention apparaîtront à la lecture de la description détaillée qui va suivre d'un mode de réalisation préféré de l'invention, pour la compréhension de laquelle on se reportera aux dessins annexés dans lesquels :
- La figure 1 est une vue de dessous d'une gaine souple de protection d'un boîtier d'un appareil de mesure prévue pour être équipée d'une poignée amovible selon l'invention ;
- la figure 2 est une vue en coupe partielle selon la ligne 2-2 de la figure 1 ;
- la figure 3 est une vue de dessous de la poignée amovible selon l'invention prévue pour équiper la gaine de boîtier représentée aux figures 1 et 2 ;
- la figure 4 est une vue en coupe de la poignée selon la ligne 4-4 de la figure 3.

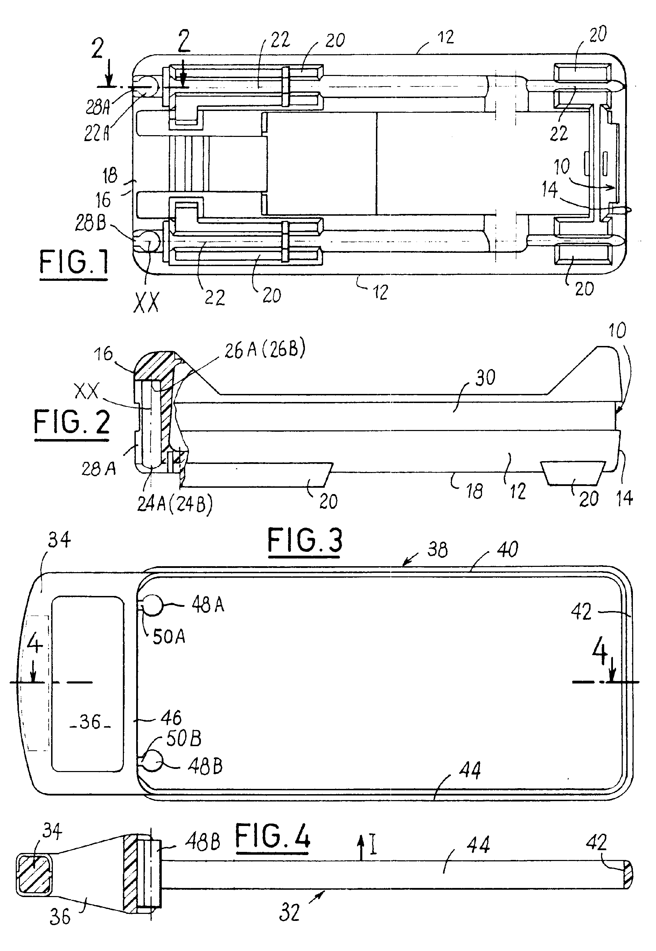

On a représenté aux figures 1 et 2 une gaine souple 10 de protection d'un boîtier d'un appareil de mesures électriques communément appelé "multimètre".

Dans l'exemple la gaine souple est une gaine amovible mais elle pourrait constituer une partie du boîtier proprement dit.

La gaine 10 présente une silhouette générale parallépipédique rectangle comportant notamment deux grandes faces latérales 12, deux petites faces latérales d'extrémité 14 et 16, et un fond 18.

Le fond 18 comporte des pieds d'appui 20 sur un plan de travail dans lesquels sont formées des rainures longitudinales permettant d'accrocher et de ranger des cordons de mesure sur la gaine.

A proximité de la face latérale d'extrémité 16, à gauche en considérant les figures, la gaine souple 20 comporte deux logements cylindriques 22A et 22B. Les deux logements sont espacés latéralement l'un de l'autre et agencés symétriquement par rapport à l'axe longitudinal médian de la gaine souple. Chaque logement 22A, 22B est ouvert à son extrémité inférieure 24A, 24B de façon à constituer une mortaise permettant de recevoir un tenon qui peut y pénétrer en coulissant axialement selon l'axe X-X du logement cylindrique.

Chaque mortaise 22A, 24A est fermée à son extrémité opposée 26A, 26B pour constituer une butée axiale du tenon.

Chaque mortaise 22A, 22B comporte une fente axiale périphérique 28A, 28B qui débouche à l'intérieur de la mortaise 22A, 22B et qui s'ouvre dans la petite face latérale d'extrémité 16.

La gaine souple 10 comporte également une rainure périphérique qui s'étend tout autour du boîtier le long des faces latérales 12, 14 et 16.

La gorge périphérique 30 est une gorge de section rectangulaire qui s'étend dans un plan perpendiculaire à la direction parallèle commune X-X des mortaises 22A, 22B et sensiblement à mi-hauteur de celles-ci.

Les mortaises et la gorge 30 sont prévues pour coopérer avec des éléments correspondants d'une poignée amovible 32 représentée aux figures 3 et 4.

La poignée amovible 32 comporte une partie de préhension 34 de forme classique comportant un évidement central 36 permettant à l'utilisateur d'y introduire ses doigts.

La partie de préhension se prolonge par une sangle en boucle fermée 38. La sangle forme une boucle rectangulaire constituée par ses trois brins consécutifs 40, 42 et 44 et qui est complétée par la portion en forme de plaque 46 qui est commune à la sangle 38 et à la partie de préhension 34.

Les dimensions et le profil de la boucle 38 sont prévus pour venir serrer élastiquement la gaine souple 10 en s'insérant dans la gorge 30. A cet effet la section des parties 40, 42 et 44 est complémentaire de celle de la gorge 30.

La sangle 38 et la partie de préhension 34 sont réalisées en un seul élément venu de matière en un matériau souple élastique tel que par exemple du caoutchouc, un élastomère, du PVC, du néoprène etc...

Afin de coopérer avec les mortaises 22A, 22B, la poignée 32 comporte deux tenons complémentaires en forme de chevilles 48A et 48B. Chaque tenon 48A, 48B est relié à la plaque 46 par une aile de liaison 50A, 50B dont l'épaisseur est telle qu'elle puisse pénétrer dans les fentes 28A et 28B de la gaine souple 10 lors de l'introduction des tenons dans les mortaises. Comme la boucle 38, les tenons 48A et 48B sont venus de matière avec la partie de préhension 34.

Les tenons 48A, 48B sont bien entendu parallèles entre eux, espacés latéralement et répartis symétriquement de manière à pouvoir pénétrer simultanément dans les mortaises 22A et 22B.

La mise en place de la poignée 32 sur la gaine 10 s'effectue de la manière suivante.

Il suffit à l'utilisateur de faire pénétrer simultanément les tenons 48A, 48B dans les mortaises 22A, 22B selon la direction d'introduction I de la figure 4 tout en faisant coulisser la boucle 38 le long des parois latérales de la gaine jusqu'à ce que la sangle pénètre dans la gorge 30. Afin de faciliter la mise en place de la sangle en déformant celle-ci élastiquement, les parois latérales 12, 14 et 16 du boîtier peuvent comporter une légère dépouille comme cela est illustré à la figure 2. On constate que lorsque la poignée amovible a été mise en place, elle présente une grande sécurité d'utilisation puisque la sangle coopère avec la gorge 30 pour empêcher que les tenons ne se dégagent accidentellement des mortaises.

La sangle a également pour fonction de répartir les efforts, lors du transport du boîtier, sur toute la périphérie de ce dernier en évitant ainsi d'appliquer des efforts trop importants à la seule paroi latérale d'extrémité 16.

En effet, dans le cas de la gaine souple 10, des efforts trop importants pourraient risquer de provoquer le démontage accidentel de la gaine par rapport au boîtier.

Dans le cas où la poignée amovible est utilisée directement sur une partie rigide du boîtier dans laquelle sont formées les mortaises, la sangle permet de répartir les efforts sur tout le boîtier en évitant une déformation de la paroi latérale d'extrémité 16 du boîtier proprement dit.

La réalisation en une seule pièce en un matériau souple ou flexible de la poignée amovible 32 est particulièrement économique. Elle constitue également une protection latérale du boîtier lorsqu'elle est en place sur ce dernier. Lorsque la poignée n'est pas utilisée, le boîtier, ou la gaine 10, présente un aspect extérieur peu modifié par rapport à l'aspect classique, la gorge 30 pouvant être formée au niveau du plan de joint du boîtier, les ouvertures d'introduction 24A, 24B étant formées dans le fond et donc invisibles en usage normal.

On peut également constater aux figures 3 et 4 que la poignée souple 32 est parfaitement symétrique par rapport à son plan général médian et qu'elle n'a donc pas de sens privilégié d'introduction ou de mise en place sur l'appareil de mesures. Comme cela a déjà été indiqué, l'invention vise tant à protéger la combinaison d'une poignée amovible avec une gaine souple de protection, qu'avec un boîtier rigide d'appareil électronique comportant des mortaises et une gorge similaire ou identique à celles qui ont été décrites et représentées dans le cas de la gaine souple, cette dernière pouvant également constituer un demi-boîtier inférieur.

## Revendications

1. Boîtier (10), notamment d'un appareil de mesures électriques, équipé d'une poignée (32) du type comportant une partie de préhension (34) et des moyens de liaison de cette partie au boîtier, caractérisé en ce que lesdits moyens de liaison sont démontables pour rendre la poignée amovible et comportent au moins un assemblage du type tenon (48A, 48B) et mortaise (22A, 22B) dont l'un des deux éléments est formé sur une portion du boîtier et une sangle (38) serrée à la périphérie (30) du boîtier (10) et qui s'étend dans un plan sensiblement perpendiculaire à la direction (X-X) de coulissement de l'assemblage par tenon et mortaise.

2. Boîtier selon la revendication 1, caractérisé en ce que le logement constituant la mortaise (22A, 22B) est fermé à l'une de ses extrémités (26A, 26B) axiales pour former une butée d'engagement du tenon.

3. Boîtier selon l'une des revendications 1 ou 2, caractérisé en ce que le tenon est un tenon en forme de cheville relié à la partie de préhension (34) par une aile axiale (50A, 50B), et en ce que la mortaise (22A, 22B) est un logement cylindrique complémentaire formé dans le boîtier (10) et qui comporte une fente (28A, 28B) axiale périphérique qui s'ouvre dans une portion de face plane (16) du boîtier (10) pour permettre le passage de l'aile de liaison (50A, 50B) du tenon (48A, 48B).

4. Boîtier selon l'une quelconque des revendications précédentes, caractérisé en ce qu'il comporte deux assemblages identiques du type tenon et mortaise qui sont parallèles entre eux.

5. Boîtier selon la revendication 4 prise en combinaison avec la revendication 3, caractérisé en ce que les deux fentes (28A, 28B) des deux mortaises (22A, 22B) s'ouvrent dans la même portion de face plane (16) du boîtier.

6. Boîtier selon l'une quelconque des revendications précédentes, caractérisé en ce que la poignée est réalisée en un matériau élastique, l'assemblage par tenon et mortaise et la sangle étant réalisé venus de matière avec la partie de préhension (34).

7. Boîtier selon l'une quelconque des revendications précédentes, caractérisé en ce que la sangle (38) est reçue dans une gorge (30) de profil complémentaire formée dans la paroi externe du boîtier.

8. Boîtier selon la revendication 7 prise en combinaison avec la revendication 6, caractérisé en ce que la sangle (38) est une sangle continue en boucle fermée emboîtée élastiquement dans la gorge (30).

9. Boîtier selon l'une quelconque des revendications précédentes, caractérisé en ce qu'il présente une forme sensiblement parallépipédique rectangle, la sangle (30) s'étendant autour des petites parois latérales (12, 14, 16) du boîtier.

10. Boîtier selon l'une quelconque des revendications précédentes, caractérisé en ce qu'il comporte une gaine souple de protection (10) à laquelle est reliée ladite poignée (32).

## Patentansprüche

1. Gehäuse (10), insbesondere für ein elektrisches Meßgerät, das mit einem Handgriff (32) versehen ist, der einen Teil (34) zum Greifen und Mittel zum Verbinden dieses Teils mit dem Gehäuse aufweist, **dadurch gekennzeichnet**, daß die Verbindungsmittel lösbar sind, um den Handgriff abnehmbar zu machen, und zumindest eine Zapfen/Zapfloch-Verbindung (48A,48B;22A,22B), von der eines der beiden Elemente an einem Bereich des Gehäuses gebildet ist, und einen Gurt (38) aufweisen, der am Umfang (30) des Gehäuses (10) eng anliegt und der sich in einer zur Bewegungsrichtung (X-X) der Zapfen-Zapfloch-Verbindung im wesentlichen senkrechten Ebene erstreckt.

2. Gehäuse nach Anspruch 1, dadurch gekennzeichnet, daß die Aufnahme, die das Zapfloch (22A,22B) bildet, an einem ihrer Enden (26A,26B) axial verschlossen ist und ein Widerlager für den Zapfen bildet.

3. Gehäuse nach Anspruch 1 oder 2, dadurch gekennzeichnet, daß der Zapfen ein Zapfen in Form eines Dübels ist, der mit dem Griffteil (34) über einen axialen Flügel (50A,50B) verbunden ist, und daß das Zapfenloch (22A,22B) eine komplementäre zylindrische Aufnahme ist, die im Gehäuse (10) gebildet ist und die einen axialen randseitigen Schlitz (28A,28B) besitzt, der sich in einen Bereich der ebenen Stirnfläche (16) des Gehäuses (10) öffnet und so das Einführen des Verbindungsflügels (50A,50B) des Zapfens (48A,48B) ermöglicht.

4. Gehäuse nach einem der vorhergehenden Ansprüche, dadurch gekennzeichnet, daß es zwei identische Zapfen/Zapfenloch-Verbindungen, die parallel zueinander angeordnet sind, aufweist.

5. Gehäuse nach Anspruch 4 und in Kombination mit Anspruch 3, dadurch gekennzeichnet, daß die beiden Schlitze (28A,28B) der beiden Zapfenlöcher (22A,22B) sich in denselben Bereich der ebenen Stirnfläche (16) des Gehäuses öffnen.

6. Gehäuse nach einem der vorhergehenden Ansprüche, dadurch gekennzeichnet, daß der Handgriff aus einem elastischen Material ist, wobei die Zapfen/Zapfloch-Verbindung und der Gurt einstückig mit dem Griffteil (34) sind.

7. Gehäuse nach einem der vorhergehenden Ansprüche, dadurch gekennzeichnet, daß der Gurt (38) in einem Einschnitt (30) komplementären Profils, der in der Außenwand des Gehäuses gebildet ist, aufgenommen ist.

8. Gehäuse nach Anspruch 7 und in Kombination mit Anspruch 6, dadurch gekennzeichnet, daß der Gurt (38) ein Gurt ist, der sich in einer geschlossenen, in dem Einschnitt (30) elastisch aufgenommenen Schleife fortsetzt.

9. Gehäuse nach einem der vorhergehenden Ansprüche, dadurch gekennzeichnet, daß es eine im wesentlichen quaderförmige Gestalt besitzt, wobei sich der Gurt (30) um die schmalen Seitenwände (12,14,16) des Gehäuses erstreckt.

10. Gehäuse nach einem der vorhergehenden Ansprüche, dadurch gekennzeichnet, daß es eine weiche Schutzhülle (10) aufweist, mit welcher der Handgriff (32) verbunden ist.

## Claims

1. Casing (10), particularly for an electrical measuring instrument, which is equipped with a handle (32) of the type comprising a gripping part (34) and means for connecting said part to the casing, characterized in that said connection means are detachable in order to make the handle removable and comprise at least one connection of the tenon (48A, 48B) and mortise (22A, 22B) type, in which one of the two elements is formed on a portion of the casing, and a strap (38) hugging the periphery (30) of the casing (10) and extending in a plane substantially at right angles to the direction (X-X) of the sliding movement of the tenon and mortise connection.

2. Casing according to Claim 1, characterized in that the socket constituting the mortise (22A, 22B) is closed at one axial end (26A, 26B) in order to form a stop the engagement of the tenon.

3. Casing according to one of Claims 1 and 2, characterized in that the tenon is a peg-shaped tenon connected to the gripping part (34) by an axial web (50A, 50B), and in that the mortise (22A, 22B) is a complementary cylindrical socket formed in the casing (10) and provided with a peripheral axial slot (28A, 28B) which opens into a plane face portion (16) of the casing (10) in order to allow the passage of the connecting web (50A, 50B) of the tenon (48A, 48B).

4. Casing according to any one of the preceding claims, characterized in that it has two identical tenon and mortise type connections which are parallel to one another.

5. Casing according to Claim 4 taken in conjunction with Claim 3, characterized in that the two slots (28A, 28B) of the two mortises (22A, 22B) open into the same plane face portion (16) of the casing.

6. Casing according to any one of the preceding claims, characterized in that the handle is made of elastic material, while the tenon and mortise connection and the strap are made in one piece with the gripping part (34).

7. Casing according to any one of the preceding claims, characterized in that the strap (38) is received in a groove (30) formed in the outer wall of the casing and having a complementary profile.

8. Casing according to Claim 7 taken in conjunction with Claim 6, characterized in that the strap (38) is an endless strap forming a closed loop and fitting elastically into the groove (30).

9. Casing according to any one of the preceding claims, characterized in that it has a substantially right parallelepipedic shape, while the strap (38) extends around the small side walls (12, 14, 16) of the casing.

10. Casing according to any one of the preceding claims, characterized in that it is provided with a flexible protective sheath (10) to which said handle (32) is connected.
